(19) **Europäisches Patentamt**

**European Patent Office**

**Office européen des brevets**

(11) Veröffentlichungsnummer: **0 320 598 B1**

(12) **EUROPÄISCHE PATENTSCHRIFT**

(45) Veröffentlichungstag der Patentschrift: **30.12.92**

(51) Int. Cl.⁵: **H03C 3/09**, H03J 7/18

(21) Anmeldenummer: **88117279.5**

(22) Anmeldetag: **18.10.88**

(54) Verfahren zur Abstimmung eines HF-Modulators.

(30) Priorität: **16.12.87 DE 3742654**

(43) Veröffentlichungstag der Anmeldung:
**21.06.89 Patentblatt 89/25**

(45) Bekanntmachung des Hinweises auf die
Patenterteilung:
**30.12.92 Patentblatt 92/53**

(84) Benannte Vertragsstaaten:
**DE FR GB IT**

(56) Entgegenhaltungen:
**EP-A- 0 116 350**
**EP-A- 0 285 926**
**US-A- 4 500 920**

(73) Patentinhaber: **GRUNDIG E.M.V. Elektro-**
**Mechanische Versuchsanstalt Max Grundig**
**holländ. Stiftung & Co. KG.**
**Kurgartenstrasse 37**
**W-8510 Fürth/Bay.(DE)**

(72) Erfinder: **Schülein, Reinhard c/o Grundig**
**E.M.V.**
**Max Grundig holländ. Stiftung & Co. KG.**
**Kurgartenstrasse 37 D-8510 Fürth/Bay(DE)**

## Beschreibung

Die Erfindung betrifft ein Verfahren zur Abstimmung eines HF-Modulators, der in einem Videorecorder mit automatisch abgleichbarem Tuner betrieben und über einen spannungsgesteuerten Oszillator abgestimmt wird. Hierbei wird zur Feinabstimmung das Ausgangssignal des auf einen geeigneten Kanal eingestellten spannungsgesteuerten Oszillators über den entsprechend abgestimmten und abgeglichenen Tuner verstärkt. Der Pegel des verstärkten Oszillatorsignals wird ausgewertet und in Abhängigkeit hiervon ein Regelsignal gebildet, das die Feinabstimmung des Modulators solange verändert, bis der Pegel des verstärkten Oszillatorsignals ein Maximum erreicht. Ein derartiges Verfahren ist in der deutschen Patentanmeldung P 37 11 983.4 beschrieben.

Der Nachteil dieses Verfahrens liegt insbesondere darin, daß die Wahl eines geeigneten Kanals, auf den der Modulator abgestimmt werden soll, manuell erfolgen muß. Erst die anschließende Feinabstimmung läuft automatisch ab. Abgesehen von der manuellen Kanalwahl an sich, besteht ferner der Nachteil, daß nicht immer der günstigste freie Kanal für den Modulator ausgewählt wird.

Der Erfindung liegt die Aufgabe zugrunde, ein Verfahren der im Oberbegriff des Patentanspruchs angegebenen Art so auszubilden, daß eine schnelle und präzise Modulatorabstimmung gewährleistet ist, und daß für die Modulatorabstimmung automatisch stets der günstigste freie Kanal ausgewählt wird.

Diese Aufgabe wird gemäß der Erfindung durch die im Kennzeichen des Patentanspruchs angegebenen Maßnahmen gelöst.

Bei dem Verfahren gemäß der Erfindung wird über den automatisch abgleichbaren Tuner die am Empfangsort vorliegende Kanalbelegung der empfangbaren Sender ermittelt. Ferner wird ein fest abgespeicherter Abstimmbereich des Modulators kanalweise abgefragt, um die für die Kanalwahl des Modulators noch in Frage kommenden freien Kanäle zu ermitteln. Von den in Frage kommenden Kanälen wird schließlich derjenige ausgewählt, der mit Rücksicht auf die am Empfangsort belegten Kanäle die größten Kanalabstände aufweist.

Der Abstimmbereich des Modulators (z. B. Kanäle 30 bis 40) wird in vorteilhafter Weise im Speicher eines Mikrocomputers abgelegt. Die am jeweiligen Empfangsort vorliegende Kanalbelegung kann z. B. durch einen Suchlauf des Tuners ermittelt und gleichfalls im Speicher eines Mikrocomputers abgelegt werden. Der Mikrocomputer kann dann durch einen Vergleich des Modulatorabstimmbereiches und der ermittelten Kanalbelegung den geeignetsten Kanal im Hinblick auf große Kanalabstände und damit auf einen optimalen Störabstand auswählen.

Als Anordnung zur Durchführung des Verfahrens gemäß der Erfindung eignet sich die in der Patentanmeldung P 37 11 983.4 bereits dargestellte Anordnung, die dort für die Feinabstimmung des Modulators beschrieben ist. Die betreffende Anordnung ist im folgenden anhand einer entsprechenden Figur auch für die automatische Kanalwahl erläutert.

Die dargestellte Blockschaltung zeigt einen abzustimmenden Modulator 6 mit einem spannungsgesteuerten Oszillator 2, dessen Ausgang über einen Signalweg 1 mit dem Eingang eines im Videorecorder ohnehin vorhandenen, vorzugsweise automatisch abgleichbaren Tuners 3 verbunden ist. Der Signalweg 1 ist bei dem hier gezeigten Beispiel als Umschalter mit einem Antennenverstärker ausgebildet, der es erlaubt, dem Tuner wahlweise das Oszillatorsignal, oder über den Antennenverstärker ein Antennensignal (Empfangssignal) zuzuführen. Ein Ausgang des Tuners 3, an dem das selektiv verstärkte und vorzugsweise gleichgerichtete Eingangssignal abgreifbar ist, steht mit einem im Videorecorder gleichfalls bereits vorhandenen Mikrocomputer 4 in Verbindung, der über einen Digital-Analog-Converter (DAC) die Abstimmung des Oszillators 2 steuert.

Für die automatische Kanalwahl (Grobabstimmung des Modulators) wird dem Tuner 3 über den Signalweg 1 das Antennensignal zugeführt. Durch einen Suchlauf, der über den Tuner durchführbar ist, kann nun die am Empfangsort vorliegende Kanalbelegung der empfangbaren Sender ermittelt werden, die gleichzeitig in einem Speicher des Mikrocomputers 4 abgelegt wird. Im Speicher des Mikrocomputers 4 ist ferner der Abstimmbereich des Modulators (z. B. Kanäle 30 bis 40) abgelegt. Anhand dieser Informationen kann der Mikrocomputer mit Rücksicht auf die Kanalabstände zwischen belegten und freien Kanälen den geeignetsten freien Kanl auswählen und über den Digital-Analog-Converter 5 die entsprechende Grobabstimmung des Oszillators 2 vornehmen.

Für die anschließende Feinabstimmung des Modulators wird das Antennen- bzw. Empfangssignal von Tuner 3 getrennt und an dessen Stelle das Ausgangssignal des Oszillators 2 dem Tuner zugeführt. Gleichzeitig wird auch der automatisch abgleichbare Tuner auf den für den Modulator ausgewählten Kanal abgestimmt. Die nun folgende Feinabstimmung ist Gegenstand der älteren Patentanmeldung P 37 11 983.4 und dort beschrieben. Es kann daher an dieser Stelle auf eine nähere Erläuterung des Feinabstimmvorgangs verzichtet werden.

Was die Kanalwahl anbelangt, so wird durch das Verfahren gemäß der Erfindung nunmehr auch der günstigste freie Kanal stets automatisch ermittelt.

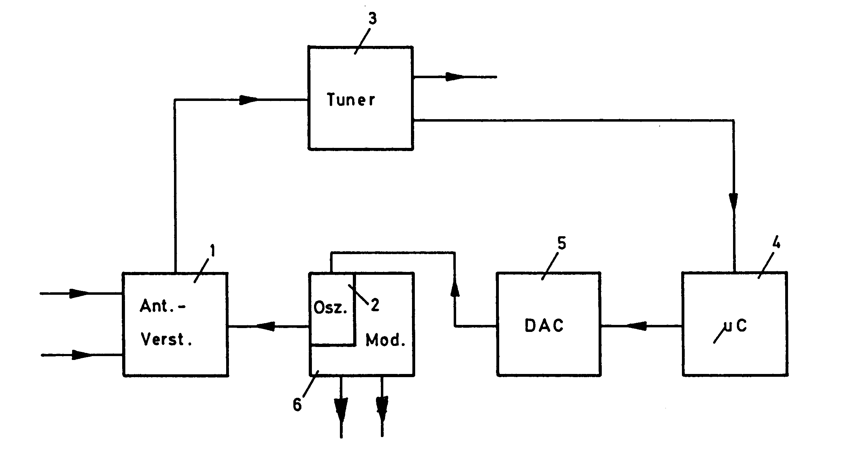

**Patentansprüche**

1. Verfahren zur Abstimmung eines HF-Modulators, der ausgangsseitig in einem Videorecorder mit automatisch abgleichbarem Tuner betrieben und über einen spannungsgesteuerten Oszillator abgestimmt wird, wobei zur Feinabstimmung das Ausgangssignal des auf einen geeigneten Kanal eingestellten spannungsgesteuerten Oszillators über den entsprechend abgestimmten und abgeglichenen Tuner verstärkt wird, der Pegel des verstärkten Oszillatorsignals ausgewertet wird und in Abhängigkeit vom Pegel des verstärkten Oszillatorsignals ein Regelsignal gebildet wird, das die Feinabstimmung des Modulators solange verändert, bis der Pegel des verstärkten Oszillatorsignals ein Maximum erreicht, **dadurch gekennzeichnet,** daß die vor der Feinabstimmung durchzuführende Einstellung eines geeigneten Kanals automatisch erfolgt, und zwar derart, daß über den automatisch abgleichbaren Tuner die am Empfangsort vorliegende Kanalbelegung der empfangbaren Sender ermittelt wird, daß ein fest abgespeicherter Abstimmbereich des Modulators kanalweise abgefragt wird, um die für die Kanalwahl des Modulators noch in Frage kommenden freien Kanäle zu ermitteln, und daß von den in Frage kommenden Kanäle derjenige ausgewählt wird, der mit Rücksicht auf die am Empfangsort belegten Kanäle die größten Kanalabstände aufweist.

**Claims**

1. Method for tuning an RF modulator which is operated at the output end in a video recorder with automatically calibratable tuner and is tuned via a voltage-controlled oscillator, the output signal of the voltage-controlled oscillator set to a suitable channel being amplified for fine tuning via the correspondingly tuned and calibrated tuner, the level of the amplified oscillator signal being evaluated and, in dependence on the level of the amplified oscillator signal, a control signal being formed which changes the fine tuning of the modulator until the level of the amplified oscillator signal reaches a peak, characterised in that the setting of a suitable channel to be carried out before the fine tuning is automatic, in such a manner that the channel allocation of the receivable transmitters available at the receiving site is determined via the automatically calibratable tuner, in that a permanently stored tuning range of the modulator is interrogated channel by channel in order to determine the free channels still available for the channel selection of the modulator, and in that of the available channels, the one having the greatest channel spacings with regard to the channels allocated at the receiving site is selected.

**Revendications**

1. Procédé de syntonisation d'un modulateur HF, qui fonctionne côté sortie dans un enregistreur vidéo, avec un syntoniseur pouvant être accordé automatiquement et est syntonisé par l'intermédiaire d'un oscillateur commandé par la tension, selon lequel pour réaliser le réglage d'accord fin, le signal de sortie de l'oscillateur commandé par la tension et réglé sur un canal approprié est amplifié par l'intermédiaire du syntoniseur réglé et équilibré de façon correspondante, le niveau du signal amplifié de l'oscillateur est évalué, et, en fonction du niveau du signal amplifié de l'oscillateur, on forme un signal de régulation, qui modifie le réglage d'accord fin du modulateur jusqu'à ce que le niveau du signal amplifié de l'oscillateur atteigne un maximum, caractérisé en ce que le réglage, qui doit être exécuté avant le réglage d'accord fin, d'un canal approprié s'effectue de façon automatique, et ce de telle sorte que l'occupation des canaux, présente sur le lieu de réception, des émetteurs pouvant être **reçus** sont déterminés par l'intermédiaire du syntoniseur pouvant être équilibré de façon automatique, qu'une plage, mémorisée de façon fixe, de réglage d'accord du modulateur est interrogée canal par canal de manière à déterminer les canaux libres, qui peuvent encore être utilisés pour la sélection de canaux du modulateur, et que parmi les canaux disponibles, on sélectionne **le canal** qui possède la distance maximale entre canaux, compte tenu des canaux occupés sur le lieu de réception.